# EUROPEAN PATENT SPECIFICATION

(11) **EP 1 194 954 B1**
(45) Date of publication and mention of the grant of the patent: **18.05.2011**
(21) Application number: 99929760.9
(22) Date of filing: 08.07.1999
(51) Int. Cl.: H01L 21/68

(54) **ELECTROSTATIC CHUCK AND ITS MANUFACTURING METHOD**
ELEKTROSTATISCHE TRÄGERPLATTE UND DAZUGEHÖRIGES HERSTELLUNGSVERFAHREN
SUPPORT ELECTROSTATIQUE ET PROCEDE DE FABRICATION CORRESPONDANT

(43) Date of publication of application: 10.04.2002
(73) Proprietor: LAM RESEARCH CORPORATION, Fremont, CA 94538 (US)
(72) Inventor: NAKAJIMA, Shu, Sagamihara-shi, Kanagawa 229-1105 (JP); TANAKA, Yasushi, Sagamihara-shi, Kanagawa 229-1105 (JP)
(74) Representative: Slingsby, Philip Roy
(86) International application number: PCT/JP1999/003701
(87) International publication number: WO 2001/004945

(56) References cited:
- EP-A- 0 791 956
- EP-A- 0 805 487
- EP-A- 0 831 526
- WO-A-96/13058
- US-A- 5 191 506
- PATENT ABSTRACTS OF JAPAN vol. 017, no. 247 (C-1059), 18 May 1993 (1993-05-18) & JP 04 371579 A (ULVAC JAPAN LTD), 24 December 1992 (1992-12-24) -& JP 04 371579 A (ULVAC JAPAN LTD) 24 December 1992 (1992-12-24)

## Description

### Field of the Invention

The present invention relates to an electrostatic chuck for use in an etching apparatus for manufacturing semiconductor and its manufacturing method.

### Background Art

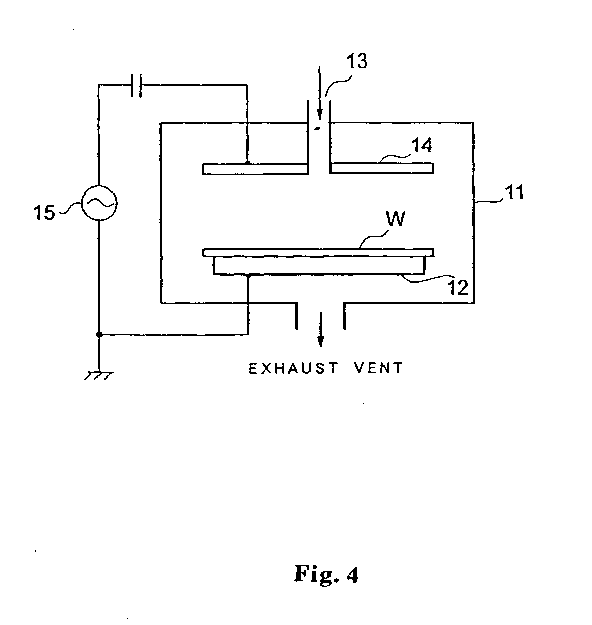

In a semiconductor manufacturing process, etching processes are repeatedly performed together with insulating film formation, diffusion processes and photolithographic processes. There are two types of etching process; wet etching and dry etching. The dry etching is implemented using a plasma etching apparatus as shown in Fig. 4, for example, with a semiconductor wafer W held on a chuck 12 in a processing chamber 11 of the etching apparatus, a reactive gas is introduced from an inlet 13 into the above-described chamber 11 while high-frequency electric power 15 is applied between the chuck 12 which serves as a lower electrode and an upper electrode 14 so as to generate a plasma in the processing chamber 11, by which chemical reaction with radical in the plasma and accelerated ions etch the semiconductor wafer W, more particularly the semiconductor wafer W itself or an insulating film (not shown) thereon.

In this dry etching, the semiconductor wafer W is held on chuck 12 as described above. Recently, for the chuck 12, an electrostatic chuck is specified due to its excellent characteristics proved in vacuum plasma processors.

The electrostatic chuck attracts material to be attracted by generating electrostatic attraction between the material to be attracted and the chuck. The electrostatic attraction is made of two types of forces; Coulomb force and Johnsen-Rahbek force.

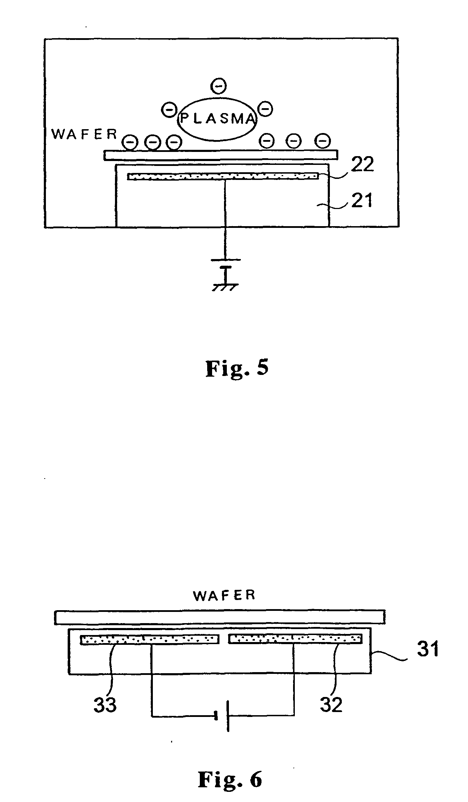

There are two types of the electrostatic chuck; one is a unipolar type in which only an anode 22 is formed in dielectric material 21 and a cathode is made of the apparatus and a plasma electric potential as shown in Fig. 5, and the other is a bipolar type in which both an anode 32 and a cathode 33 are formed in dielectric material 31 as shown in Fig. 6.

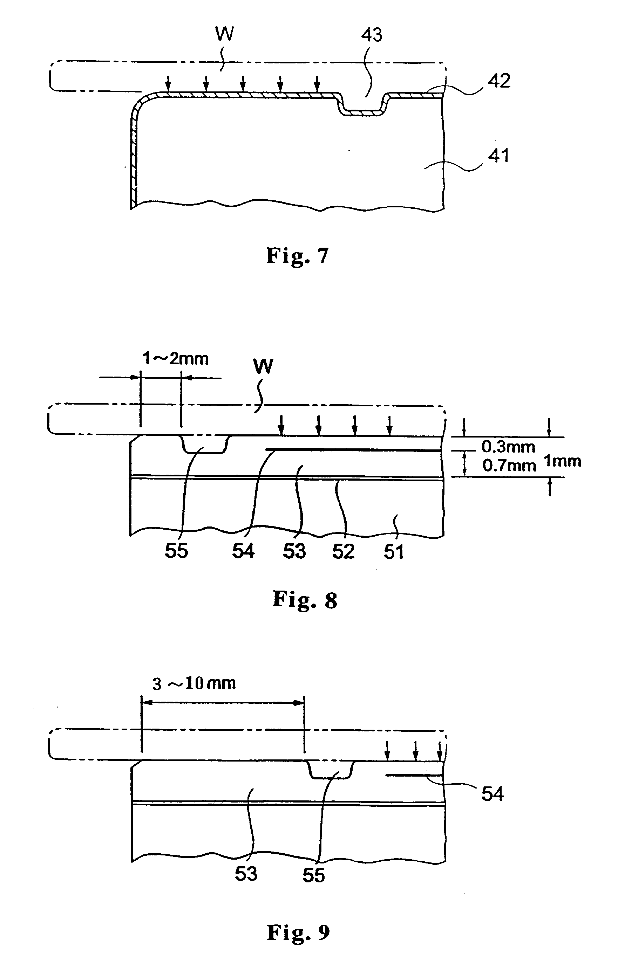

Referring to Fig. 7, there is shown a cross-sectional view illustrating an example of a conventional practically-used electrostatic chuck. This electrostatic chuck comprises an anodized aluminum film 42 which is 50 to 60 µm in thickness as dielectric material on a surface of a disc-shaped aluminum electrode 41. The anodized aluminum film 42 is the material on which the semiconductor wafer W is placed. On a surface of the aluminum electrode 41 covered by the anodized aluminum film 42, is formed a cooling gas channel 43 extending in a circumferential direction of the electrode. To this cooling gas channel 43, a helium gas is fed as cooling gas from gas feed orifices (not shown) penetrating the anodized aluminum film 42 and the aluminum electrode 41. The helium gas fed to the channel 43 flows into the channel 43, fills it, and then diffuses along the entire interface between the anodized aluminum film 42 and the semiconductor wafer W through fine gaps therebetween generated by a rough surface of the anodized aluminum film 42, thereby cooling the semiconductor wafer W. In the dry etching with the apparatus shown in Fig. 4, a temperature of the semiconductor wafer W significantly affects the etching characteristics. By cooling the semiconductor wafer W up to 30 °C to 60 °C with the above-described helium gas used as a heat conductive means, the etching characteristics, especially uniformity, are improved.

In the conventional electrostatic chuck as set forth in the above, however, there is a disadvantage that reaction products which have been floating or otherwise dispensed in the chamber 11 shown in Fig. 4 adhere to a surface of the anodized aluminum film 42, after the semiconductor wafer W is removed from the chuck after the etching process, thus weakening the electrostatic attraction. In addition, it has a problem that the reaction products adhering to the surface of the anodized aluminum film 42 increases gaps between the anodized aluminum film 42 and the semiconductor wafer W, causing leakage of the helium gas from an outer peripheral edge of the aluminum electrode 41, by which the semiconductor wafer W is insufficiently cooled by the helium gas and therefore the etching characteristics deteriorate. Furthermore, the anodized aluminum film 42 is deteriorated by the reactive gas or ions which have passed through end portions of the semiconductor wafer W during etching before reaching there, thus also weakening the electrostatic attraction.

Accordingly, there has been devised an electrostatic chuck for which a ceramic layer is used for the dielectric material as shown in Fig. 8. This electrostatic chuck has a ceramic layer 53 bonded onto a disc-shaped metal base plate 51 by means of an adhesive layer 52. A high-melting point electrode 54 is laid in the ceramic layer 53. In this arrangement, from the viewpoint of increasing the electrostatic attraction, the electrode 54 is located in the ceramic layer 53 relatively near the surface thereof. Specifically, on the assumption that the ceramic layer 53 is 1 mm in thickness, for example, the electrode 54 is located in a position spaced 0.3 mm away from the surface of the ceramic layer 53 and spaced 0.7 mm away from the bottom thereof. In the same manner as for the electrostatic chuck shown in Fig. 7, is formed a cooling gas channel 55 extending in a circumferential direction of the ceramic layer 53 on the surface thereof. This channel 55 needs a certain depth taking into consideration a flow of the helium gas. Therefore, if the above-described channel 55 is formed in the position of the electrode 54 located relatively near the surface of the ceramic layer 53, a distance between the bottom of the channel 55 and the electrode 54 becomes short, thus causing an insufficient dielectric strength of the ceramic layer 53. Accordingly, in this example, the channel 55 is formed 1 to 2 mm within the end of the ceramic layer 53, and the electrode 54 is formed further within the channel 55.

The above-described electrostatic chuck has a problem, however; the electrode 54 having a coefficient of linear thermal expansion different from that of the ceramic layer 53 is located in the ceramic layer 53 relatively near the surface thereof, which often causes a warpage of the ceramic layer 53 if the ceramic layer 53 within the electrode 54 is formed by firing. In addition, while a leakage of the helium gas fed to the channel 55 from the end portion of the ceramic layer 53 is prevented by the sealed portion between the ceramic layer 53 and the semiconductor wafer W between the channel 55 and the end portion of the ceramic layer 53, such a short distance of the sealed portion (a sealed distance) as 1 to 2 mm sometimes causes a gas leakage.

In order to prevent the gas leakage, there is also another example that the channel 55 is formed approximately 3 to 10 mm within the end of the ceramic layer 53 as shown in Fig. 9, so as to achieve a substantial sealed distance. This example also has a problem, however; the electrode 54 is formed further within the channel 55 located within the end of the ceramic layer 53, which effectively decreases an area of the electrode 54, thus causing insufficient electrostatic attraction in the helium gas sealed portion.

EP 0 805 487 describes an electrostatic chuck for holding a substrate during processing of the substrate. The chuck comprises a plurality of electrodes, covered by an insulator, capable of electrostatically holding a substrate when a voltage is applied. Fuses connect the electrodes to the voltage source. These fuses can disconnect the electrodes from the output terminals when the insulator is punctured, thereby providing protection against failure.

JP 04371579 describes an electrostatic chuck with grooves near the periphery of the chuck for introducing cooling gas. An improved method for maintaining a uniformly low temperature of the substrate is thereby provided.

EP 0 831 526 describes an electrostatic chuck with an inner electrode and a ring electrode. These electrodes have different polarities and are concentrically buried in a dielectric film. On application of a DC voltage between the electrodes, a sample is electrostatically attracted to the dielectric film. The electric charges built up on the film during application of the DC voltage substantially cancel resulting in a reduced residual attracting force on the sample.

Furthermore, there are many examples of conventional electrostatic chucks in which a wafer W attracted to a chuck cannot always be readily detached, or "dechucked" therefrom after a completion of etching or other processes. In some cases, it takes a considerable time for detachment of the wafer W.

The present invention overcomes problems associated with prior art arrangements, and provides an electrostatic chuck and its manufacturing method for preventing warpage of a ceramic layer and a cooling gas leakage in addition to having enhanced electrostatic attraction and requiring only a short time for detachment.

### Summary Disclosure of the Invention

The present invention provides an electrostatic chuck, comprising a metal base plate, a ceramic disc having a predetermined thickness adhesively bonded to said metal base plate, a planar electrode positioned in the middle of said ceramic disc relative to a thickness direction of said ceramic disc; and a cooling gas channel formed on a top surface of said ceramic disc over said electrode and within an outer peripheral edge of said electrode, said cooling gas channel defined in a ring shape along an outer peripheral edge of said ceramic disc, wherein said planar electrode (90) includes a first electrode (91) and a second electrode (92), said first electrode including a disc portion (91a) arranged in the center of said ceramic disc (80), a first extending portion (91b) extending from a part of the disc portion (91a) toward the outer peripheral edge of said ceramic disc (80), and a plurality of first C-shaped ring portions (91c) at predetermined intervals so as to have different diameters, the first C-shaped ring portions extending in C shapes from both sides of said first extending portion (91b) around said disc portion (91a), said second electrode (92) including a second extending portion (92b) arranged opposite to said first extending portion (91b) relative to said disc portion (91a) of said first electrode, a plurality of second C-shaped ring portions (92c) at predetermined intervals so as to have different diameters, the second C-shaped ring portions extending in C shapes from both sides of said second extending portion (92b) and being interleaved with said plurality of first C-shaped ring portions (91c) of said first electrode (91), and a circular ring portion (92d) connected to an outer edge of said second extending portion (92b) so as to form the outer peripheral edge of said second electrode (92).

An alternative aspect of the invention provides a method for manufacturing an electrostatic chuck comprising: preparing a first disc-shaped ceramic material compact having a half of a thickness of a completed ceramic layer, forming an electrode on a top surface of said first ceramic material compact, preparing a second disc-shaped ceramic material compact having a half of a thickness of the completed ceramic layer and having a cooling gas channel on its top surface in a location that will overlie said electrode when said second disc-shaped ceramic material compact is placed on said first disc-shaped ceramic material compact, placing said second ceramic material compact on said first ceramic material compact so as to form a laminate; firing the entire laminate to form the completed ceramic layer, and bonding the completed ceramic layer to a metal base plate by means of an adhesive layer, wherein said electrode (90) is formed to include a first electrode (91) and a second electrode (92), said first electrode formed to include a disc portion (91a) arranged in the center of said ceramic disc (80), a first extending portion (91b) extending from a part of the disc portion (91a) toward the outer peripheral edge of said ceramic disc (80), and a plurality of first C-shaped ring portions (91c) at predetermined intervals so as to have different diameters, the first C-shaped ring portions extending in C shapes from both sides of said first extending portion (91b) around said disc portion (91a), said second electrode (92) formed to include a second extending portion (92b) arranged opposite to said first extending portion (91b) relative to said disc portion (91a) of said first electrodes, and a circular ring portion (92d) connected to an outer edge of said second extending portion (92b) so as to form the outer peripheral edge of said second electrode (92).

### Brief Description of the Drawings

Fig. 1 is a cross-sectional view of an embodiment of an electrostatic chuck according to the present invention;
Fig. 2 is a top plan view of an electrode of the electrostatic chuck illustrated in Fig. 1;
Fig. 3 is a top plan view of a ceramic layer of the electrostatic chuck illustrated in Fig. 1;
Fig. 4 is a schematic view illustrating a dry etching apparatus;
Fig. 5 is a schematic view illustrating a unipolar-type electrostatic chuck;
Fig. 6 is a schematic view illustrating a bipolar-type electrostatic chuck;
Fig. 7 is a cross-sectional view illustrating a conventional first electrostatic chuck;
Fig. 8 is a cross-sectional view illustrating a conventional second electrostatic chuck; and
Fig. 9 is a cross-sectional view illustrating a conventional third electrostatic chuck;

### Detailed Description of the Invention

A description will be given of an electrostatic chuck and its manufacturing method according to the present invention, by referring to the accompanying drawings. The electrostatic chuck of the present invention is used for a dry etching apparatus. A general configuration of the dry etching apparatus is shown in Fig. 4. Accordingly, a description of the general configuration of the dry etching apparatus is omitted here, and only the electrostatic chuck is described in detail below.

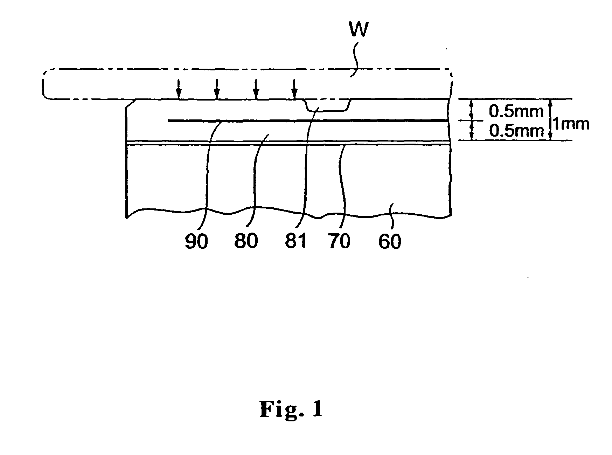

Referring to Fig. 1, there is shown a cross-sectional view of an electrostatic chuck of an embodiment according to the present invention. As shown in this diagram, in the electrostatic chuck of this embodiment, a disc-shaped ceramic layer 80 having a predetermined thickness is bonded onto a disc-shaped metal base plate 60 by means of an adhesive layer 70. In this ceramic layer 80, a planar electrode 90 made of tungsten, for example, is laid in parallel to a surface of the ceramic layer 80. At this point, the electrode 90 is formed in the ceramic layer 80 at a depth of one half of the thickness thereof, in other words, in the middle of the ceramic layer 80 in the thickness direction.

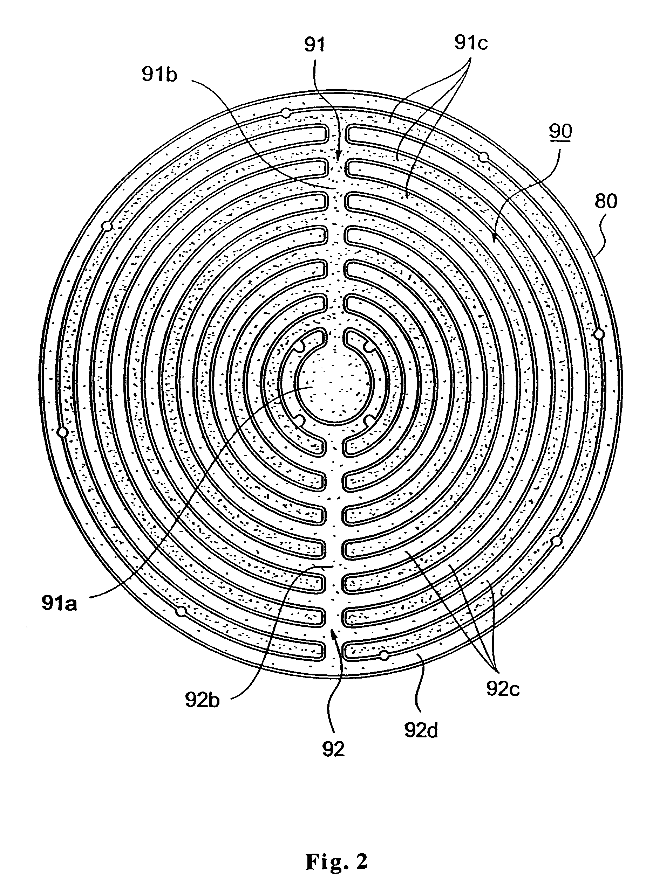

A top plan view of this electrode 90 is shown in Fig. 2. The electrode 90 comprises a first electrode 91 and a second electrode 92. Therefore, the electrostatic chuck of this embodiment is of a bipolar type as shown in Fig. 6. The first electrode 91 comprises a disc portion 91a arranged in the center of the ceramic layer 80, a linear portion 91b linearly extending from a part of the disc portion 91a toward an outer peripheral edge of the ceramic layer 80. The first electrode 91 further comprises a plurality of "C-shaped" ring portions 91c at predetermined intervals having different diameters and extending in "C" shapes on both sides of the linear portion 91b so as to surround the disc portion 91a. The second electrode 92 comprises a linear portion 92b positioned opposite to the linear portion 91b of the first electrode 91 beyond the disc portion 91a of the first electrode 91 and arranged complementary to the plurality of the C-shaped ring portions 91c of the first electrode 91, a plurality of "C-shaped" ring portions 92c at predetermined intervals having different diameters and extending in "C" shapes on both sides of the linear portion 92b, and, being engaged with the plurality of the C-shaped ring portions 91c of the first electrode 91. Furthermore, the electrode 91 comprises a circular ring portion 92d connected to an outer edge of the linear portion 92b so as to form the outermost peripheral portion of the electrode.

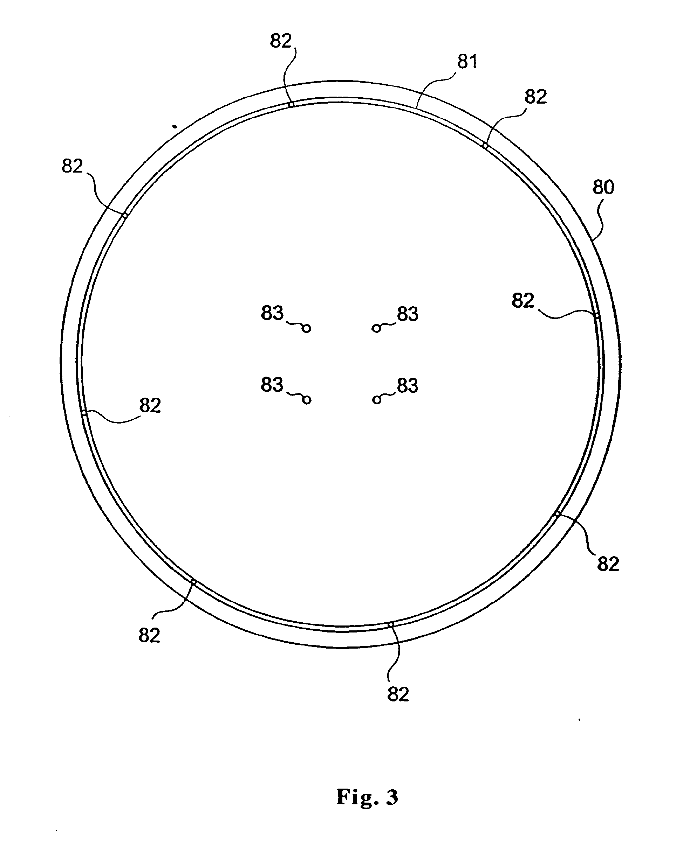

Returning to Fig. 1, a cooling gas channel 81 is formed on a surface of the ceramic layer 80. The cooling gas channel 81 is provided in a ring shape along the outer peripheral edge of the ceramic layer 80 as shown in a top plan view in Fig. 3. In addition, the channel 81 is formed within the outer peripheral edge of the electrode 90 and over the electrode 90 as shown in Fig. 1. Accordingly, the electrode 90 passes under the bottom of the channel 81 and extends beyond the channel 81 and up to the vicinity of the outer peripheral side of the ceramic layer 80.

At a bottom of the channel 81, there are gas feed orifices 82 in a plurality of positions in a circumferential direction as shown in Fig. 3. Additionally on a surface of the ceramic layer 80 in the center side, gas feed orifices 83 are arranged in a plurality of positions on a single circumference. These gas feed orifices 82 and 83 extend through the ceramic layer 80, the adhesive layer 70, and the base plate 60 up to the bottom thereof. A cooling gas such as a helium gas, for example, is fed from the bottom of the base plate 60. The helium gas fed to the gas feed orifices 82 and 83 spouts from the bottom of the channel 81 and from the surface of the ceramic layer 80 in the center and diffuses from the outer peripheral portion of the ceramic layer 80 and from the center thereof on the entire interface between the ceramic layer 80 and the semiconductor wafer W, as shown in Fig. 1, so as to cool the semiconductor wafer W.

According to the electrostatic chuck of this embodiment as described above, the electrode 90 comprising a high-melting point metal having a coefficient of linear thermal expansion different from that of the ceramic layer 80 is diposed/located in the ceramic layer 80 in the middle thereof in its thickness direction. Therefore, even if the ceramic layer 80 is formed in the electrode 90 with firing, the ceramic layer 80 is not warped so as to obtain a flat ceramic layer 80. In addition, improvement of the flatness of the ceramic layer 80 leads to improvement of etching characteristics(for example, uniformity) of the semiconductor wafer W as well as increasing the attraction of the semiconductor wafer W.

Furthermore, the cooling gas channel 81 is formed within the outer peripheral edge of the electrode 90 and over the electrode 90. Thus, the electrode 90 extends beyond the channel 81, in other words, up to the gas-sealed portion. Therefore, electrostatic attraction is also applied to the sealed portion by means of the electrode 90 as indicated by arrows, thus preventing a gas leakage from the sealed portion with the electrostatic attraction. The prevention of the gas leakage leads to improved cooling condition of the semiconductor wafer W, improving the etching characteristics, such as uniformity center-to-edge as measured on the wafer.

Furthermore, by positioning the electrode 90 in the middle (in a deep position) of the ceramic layer 80 in its thickness direction, the channel 81 can be formed sufficiently deep even if it is located over the electrode 90, by which the helium gas smoothly flows so as to cool the semiconductor wafer W favorably. In addition, by forming the channel 81 over the electrode 90, a long distance of the sealed portion can be secured by disposing the channel 81 within the ceramic layer 80, by which a gas leakage can be prevented more reliably and an area of the electrode does not need to be decreased due to a position of the channel 81. Also, even if the electrode 90 is located in a deep position in the ceramic layer 80, sufficient electrostatic attraction can be secured since electrostatic attraction is also applied to the sealed portion as described in the above.

Furthermore, by using a pattern shown in Fig. 2 for the first and second electrodes 91 and 92 of the electrode 90, the first and second electrodes 91 and 92 having an identical area can be uniformly formed all over the ceramic layer 80, by which uniform electrostatic attraction can be achieved on the entire ceramic layer 80. Still further, the ratio of the area of the electrode 91 to the area of the ceramic layer 80 can be increased, by which the electrostatic attraction is enhanced. Additionally, with the ESC of the present invention, detaching or "dechucking" performance of a wafer after processing is improved in comparison with an ESC made with conventional doughnut or threading pattern, where the conventional pattern causes an uneven ratio of an area of the first electrode to that of the second electrode, thus leading to a maldistribution of electric charges and causing poor dechucking performance.

### Embodiment

The base plate 60 is preferably formed by using an aluminum 6061, for example. A high radio frequency(RF) power is fed to this base plate 60 in order to generate a plasma in a chamber 11 of an apparatus shown in Fig. 4. The high radio frequency power to be applied may be in the range of 1 to 40 MHz in frequency and of 15 to 3000 W in power.

For the adhesive layer 70, a suitable, flexible, preferably organic, adhesive is used. With the ceramic layer 80 bonded to the base plate 60 by means of the flexible organic adhesive, the ceramic layer 80 is prevented from cracking caused by differential stress due to a difference of a coefficient of linear thermal expansion.

The ceramic layer 80 is formed by adding conductive additive to aluminum oxide, for example, aluminum nitride, or magnesium oxide. In this embodiment, it is formed by using a material of Al₂O₃ as a predominant component, and TiO₂ and glass firing auxiliary material as additives. The additive TiO₂ is added to cause the ceramic layer 80 to be slightly conductive so as to let electric charges for generating electrostatic attraction rise from the electrode 90 up to the surface of the ceramic layer 80. A resistivity of the ceramic layer 80 is selected so that it is within a range of 10¹¹-10¹² Ω/cm, and preferably within a range of 1.0 to 2.0 x 10¹¹ Ω/cm.

A diameter of the ceramic layer 80 is slightly smaller than that of the semiconductor wafer W, and a thickness of the ceramic layer 80 is approximately 1 mm taking into consideration dielectric breakdown and an energy loss of the high-frequency power. Surface roughness of the ceramic layer 80 is Ra≒0.8 µm and flatness thereof is 5 µm or lower. The outer peripheral edge on the surface of the ceramic layer 80 is chamfered by 0.2 to 0.25 mm.

The cooling gas channel 81 is formed so as to extend 5 mm within the outer peripheral edge of the ceramic layer 80 and to be 1 mm wide and 0.25 mm deep. On the bottom surface of the cooling gas channel 81, eight gas feed orifices 82 are formed at 45° intervals in a circumferential direction. On the surface of the ceramic layer 80 in the center side, four gas feed orifices 83 are formed at 90° intervals on the circumference of 0.35 mm diameter. Each gas feed orifice 82 on the bottom surface of the cooling gas channel 81 is 0.32 mm in diameter and each gas feed orifice 83 on the surface of the ceramic layer 80 in the center side is 0.35 mm in diameter. The gas feed orifices 83 on the surface of the ceramic layer 80 in the center side serve as insertion orifices of pins for lifting the semiconductor wafer W, and therefore they are formed so as to be slightly larger than the gas feed orifices 82 on the bottom surface of the channel 81.

The electrode 90 (consisting of the first and second electrodes 91 and 92) is made of tungsten which is 10-20 µm in thickness. This electrode 90 is approximately 1 mm smaller than the ceramic layer 80 in radius and it is laid in a position spaced 0.5 mm away from the surface and 0.5 mm away from the bottom of the ceramic layer 80 having a thickness of 1 mm. In other words, the electrode 90 is positioned in the middle of the ceramic layer 80 in a thickness direction.

The disc portion 91a of the first electrode 91 shown in Fig. 2 is approximately 30 mm in diameter. The linear portion 91b of the first electrode 91 and the linear portion 92b of the second electrode 92 are approximately 6.0 mm wide. There are seven C-shaped ring portions 91c of the first electrode 91 having consecutively increasing diameters and seven C-shaped ring portions 92c of the second electrode 92 having consecutively increasing diameters. A single circular ring portion 92d of the second electrode 92 is provided on the outermost periphery. The C-shaped ring portions 91c of the first electrode 91, the C-shaped ring portions 92c of the second electrode 92, and the circular ring portion 92d have widths slightly different each other, and their average width is approximately 5.0 mm. Respective portions of the first electrode 91 are spaced 1.0 mm away from respective corresponding portions of the second electrode 92. The total area of the first electrode 91 is 128.3 cm² and that of the second electrode 92 is nearly the same size, 128.4 cm².

### <Manufacturing method>

Preparing a first disc-shaped ceramic material compact having a half of a thickness of a ceramic layer 80, an electrode is formed on a surface of the first ceramic material compact in a screen process printing method. Preparing a second disc-shaped ceramic material compact having a half of the thickness of the ceramic layer 80 and including a cooling gas channel on its surface within the electrode, the second ceramic material compact is placed on the above-described first ceramic material compact for contact bonding. Afterward, the entire material is fired to complete the ceramic layer 80. In this process, no warpage occurs since the electrode is located in the middle of the ceramic layer 80 in a thickness direction. Subsequently the ceramic layer 80 is bonded to an aluminum base plate 60 by means of an adhesive layer 70.

### <Other applications>

While the invention has been described above by way of an example of an electrostatic chuck according to the present invention applied to a dry etching apparatus, the electrostatic chuck of the present invention may be also be implemented within a CVD apparatus or the like, for example a target. In addition, it can be adapted for use in a chuck for electrostatically attracting material other than semiconductor wafers, for example, ceramic substrates.

### Industrial Applicability

As described in detail hereinabove, according to an electrostatic chuck of the present invention and its manufacturing method, warpage of a ceramic layer is prevented. Furthermore, it prevents a cooling gas leakage at the periphery and increases an electrostatic attraction.

## Claims

1. An electrostatic chuck, comprising:
a metal base plate (60);
a ceramic disc (80) having a predetermined thickness adhesively bonded to said metal base plate (60);
a planar electrode (90) positioned in the middle of said ceramic disc relative to a thickness direction of said ceramic disc; and
a cooling gas channel (81) formed on a top surface of said ceramic disc over said electrode and within an outer peripheral edge of said electrode, said cooling gas channel (81) defined in a ring shape along an outer peripheral edge of said ceramic disc (80), wherein said planar electrode (90) includes a first electrode (91) and a second electrode (92),
said first electrode including
a disc portion (91a) arranged in the center of said ceramic disc (80),
a first extending portion (91b) extending from a part of the disc portion (91a) toward the outer peripheral edge of said ceramic disc (80), and
a plurality of first C-shaped ring portions (91c) at predetermined intervals so as to have different diameters, the first C-shaped ring portions extending in C shapes from both sides of said first extending portion (91b) around said disc portion (91a),
said second electrode (92) including
a second extending portion (92b) arranged opposite to said first extending portion (91b) relative to said disc portion (91a) of said first electrode,
a plurality of second C-shaped ring portions (92c) at predetermined intervals so as to have different diameters, the second C-shaped ring portions extending in C shapes from both sides of said second extending portion (92b) and being interleaved with said plurality of first C-shaped ring portions (91c) of said first electrode (91), and
a circular ring portion (92d) connected to an outer edge of said second extending portion (92b) so as to form the outer peripheral edge of said second electrode (92).

2. An electrostatic chuck according to claim 1, wherein said planar electrode (90) extends beyond said cooling gas channel (81).

3. An electrostatic chuck according to claim 1, wherein said chuck further comprises gas feed orifices (82) located in a plurality of positions at a bottom portion of said gas cooling channel (81) and gas feed orifices (83) located in a plurality of positions on a circumference on a surface of said ceramic disc (80) in the center side of the chuck.

4. A method for manufacturing an electrostatic chuck comprising:
preparing a first disc-shaped ceramic material compact having a half of a thickness of a completed ceramic disc (80);
forming an electrode (90) on a top surface of said first ceramic material compact;
preparing a second disc-shaped ceramic material compact having a half of a thickness of the completed ceramic disc and having a cooling gas channel (81) on its top surface in a location that will overlie said electrode when said second disc-shaped ceramic material compact is placed on said first disc-shaped ceramic material compact;
placing said second ceramic material compact on said first ceramic material compact so as to form a laminate;
firing the entire laminate to form the completed ceramic disc (80); and
bonding the completed ceramic layer to a metal base plate (60) by means of an adhesive layer (70),
wherein said electrode (90) is formed to include a first electrode (91) and a second electrode (92),
said first electrode formed to include
a disc portion (91a) arranged in the center of said ceramic disc (80),
a first extending portion (91b) extending from a part of the disc portion (91a) toward the outer peripheral edge of said ceramic disc (80), and
a plurality of first C-shaped ring portions (91c) at predetermined intervals so as to have different diameters, the first C-shaped ring portions extending in C shapes from both sides of said first extending portion (91b) around said disc portion (91a),
said second electrode (92) formed to include
a second extending portion (92b) arranged opposite to said first extending portion (91b) relative to said disc portion (91a) of said first electrode,
a plurality of second C-shaped ring portions (92c) at predetermined intervals so as to have different diameters, the second C-shaped ring portions extending in C shapes from both sides of said second extending portion (92b) and being interleaved with said plurality of first C-shaped ring portions (91c) of said first electrode (91), and
a circular ring portion (92d) connected to an outer edge of said second extending portion (92b) so as to form the outer peripheral edge of said second electrode (92).

5. A method according to claim 4, wherein said adhesive layer (70) is flexible.

6. An electrostatic chuck according to claim 1, wherein the planar electrode (90) extends radially to within approximately one millimeter of an outer peripheral edge of the ceramic disc (80).

7. An electrostatic chuck according to claim 1, wherein each of the first and second electrodes (91 and 92) are made of tungsten having a thickness within a range extending from 10 micrometers to 20 micrometers.

8. An electrostatic chuck according to claim 1, wherein the disc portion (91a) of the first electrode (91) has a diameter of approximately 30 millimeters, and the plurality of first C-shaped ring portions (91c) of the first electrode (91), the plurality of second C-shaped ring portions (92c) of the second electrode (92), and the circular ring portion (92d) of the second electrode (92) have an average width of approximately 5 millimeters.

9. An electrostatic chuck according to claim 1, wherein the first extending portion (91b) and the second extending portion (92b) have widths of approximately 6 millimeters.

10. An electrostatic chuck according to claim 1, wherein a spacing of one millimeter is maintained between respective portions of the first and second electrodes (91 and 92).

11. An electrostatic chuck as recited in claim 1, wherein a total area of the first electrode (91) is approximately equal to a total area of the second electrode (92).

## Patentansprüche

1. Elektrostatische Aufspannvorrichtung, mit
einer metallischen Grundplatte (60);
einer Keramikscheibe (80), die eine vorbestimmte Dicke aufweist und mit der metallischen Grundplatte verklebt ist;
einer ebenen Elektrode (90), die relativ zu einer Dickenrichtung der Keramikscheibe in der Mitte der Keramikscheibe positioniert ist; und
einem Kühlgaskanal (81), der auf einer Oberfläche der Keramikscheibe über der Elektrode und innerhalb eines äußeren Umfangrands der Elektrode ausgebildet ist, wobei der Kühlgaskanal (81) ringförmig entlang eines äußeren Umfangrands der Keramikscheibe (80) festgelegt ist, und wobei die ebene Elektrode (90) eine erste Elektrode (91) und eine zweite Elektrode (92) umfasst,
wobei die erste Elektrode umfasst:
einen Scheibenbereich (91a), der im Zentrum der Keramikscheibe (80) angeordnet ist;
einen ersten Erstreckungsbereich (91b), der sich von einem Teil des Scheibenbereichs (91a) zum äußeren Umfangrand der Keramikscheibe (80) hin erstreckt; und
mehrere erste C-förmige Ringbereiche (91c) in vorbestimmten Abständen, so dass sie unterschiedliche Durchmesser aufweisen, wobei sich die ersten C-förmigen Ringbereiche ausgehend von beiden Seiten des ersten Erstreckungsbereichs (91b) C-förmig um den Scheibenbereich (91a) herum erstrecken;
und wobei die zweite Elektrode (92) umfasst:
einen zweiten Erstreckungsbereich (92b), der, bezüglich des Scheibenbereichs (91 a) der ersten Elektrode, gegenüber dem ersten Erstreckungsbereich (91b) angeordnet ist;
mehrere zweite C-förmige Ringbereiche (92c) in vorbestimmten Abständen, so dass sie unterschiedliche Durchmesser aufweisen, wobei sich die zweiten C-förmigen Ringbereiche ausgehend von beiden Seiten des zweiten Erstreckungsbereichs (92b) C-förmig erstrecken, und wobei sie mit den mehreren ersten C-förmigen Ringbereichen (91c) der ersten Elektrode (92) verschachtelt sind; und
einen kreisförmigen Ringbereich (92d), der mit einem äußeren Ende des zweiten Erstreckungsbereichs (92b) verbunden ist, um den äußeren Umfangrand der zweiten Elektrode (92) zu bilden.

2. Elektrostatische Aufspannvorrichtung nach Anspruch 1, wobei sich die ebene Elektrode (90) über den Kühlgaskanal (81) hinaus erstreckt.

3. Elektrostatische Aufspannvorrichtung nach Anspruch 1, wobei die Aufspannvorrichtung weiter Gaszuführöffnungen (82) umfasst, die sich an mehreren Positionen eines Bodenbereichs des Kühlgaskanals (81) befinden, sowie Gaszuführöffnungen (83), die sich an mehreren Positionen auf einem Umfang an einer Oberfläche der Keramikscheibe (80) in der Mitte der Aufspannvorrichtung befinden.

4. Verfahren zur Herstellung einer elektrostatischen Aufspannvorrichtung, umfassend:
Vorbereiten eines ersten scheibenförmigen Keramikmaterialkörpers, der die Hälfte einer Dicke einer fertigen Keramikscheibe (80) aufweist;
Ausbilden einer Elektrode (90) auf einer Oberfläche des ersten Keramikmaterialkörpers;
Vorbereiten eines zweiten scheibenförmigen Keramikmaterialkörpers, der die Hälfte einer Dicke der fertigen Keramikscheibe (80) aufweist, und der einen Kühlgaskanal (81) auf seiner Oberfläche an einem Ort aufweist, der die Elektrode überlagern wird, wenn der zweite scheibenförmige Keramikmaterialkörper auf dem ersten scheibenförmigen Keramikmaterialkörper platziert wird;
Platzieren des zweiten Keramikmaterialkörpers auf dem ersten Keramikmaterialkörper, um einen Verbund zu bilden;
Brennen des gesamten Verbunds, um die fertige Keramikscheibe (80) auszubilden; und
Verbinden der fertigen Keramikscheibe mit einer metallischen Grundplatte (60) mittels einer Klebeschicht (70),
wobei die Elektrode (90) so ausgebildet ist, dass sie eine erste Elektrode (91) und eine zweite Elektrode (92) umfasst,
wobei die erste Elektrode so ausgebildet ist, dass sie umfasst:
einen Scheibenbereich (91a), der im Zentrum der Keramikscheibe (80) angeordnet ist;
einen ersten Erstreckungsbereich (91b), der sich von einem Teil des Scheibenbereichs (91a) zum äußeren Umfangrand der Keramikscheibe (80) hin erstreckt; und
mehrere erste C-förmige Ringbereiche (91c) in vorbestimmten Abständen, so dass sie unterschiedliche Durchmesser aufweisen, wobei sich die ersten C-förmigen Ringbereiche ausgehend von beiden Seiten des ersten Erstreckungsbereichs (91b) C-förmig um den Scheibenbereich (91a) herum erstrecken;
und wobei die zweite Elektrode so ausgebildet ist, dass sie umfasst:
einen zweiten Erstreckungsbereich (92b), der bezüglich des Scheibenbereichs (91a) der ersten Elektrode dem ersten Erstreckungsbereich (91b) gegenüberliegend angeordnet ist;
mehrere zweite C-förmige Ringbereiche (92c) in vorbestimmten Abständen, so dass sie unterschiedliche Durchmesser aufweisen, wobei sich die zweiten C-fönnigen Ringbereiche ausgehend von beiden Seiten des zweiten Erstreckungsbereichs (92b) C-förmig erstrecken, und mit den mehreren ersten C-förmigen Ringbereichen (91c) der ersten Elektrode (92) verschachtelt sind; und
einen kreisförmigen Ringbereich (92d), der mit einem äußeren Ende des zweiten Erstreckungsbereichs (92b) verbunden ist, um den äußeren Umfangrand der zweiten Elektrode (92) zu bilden.

5. Verfahren nach Anspruch 4, wobei die Klebeschicht (70) flexibel ist.

6. Elektrostatische Aufspannvorrichtung nach Anspruch 1, wobei sich die ebene Elektrode (90) radial bis auf etwa einen Millimeter an einen äußeren Umfangrand der Keramikscheibe (80) heran erstreckt.

7. Elektrostatische Aufspannvorrichtung nach Anspruch 1, wobei jede der ersten und zweiten Elektroden (91 und 92) aus Wolfram besteht und eine Dicke im Bereich von 10 bis 20 Mikrometer aufweist.

8. Elektrostatische Aufspannvorrichtung nach Anspruch 1, wobei der Scheibenbereich (91a) der ersten Elektrode (91) einen Durchmesser von etwa 30 Millimeter aufweist, und die mehreren ersten C-förmigen Ringbereiche (91c) der ersten Elektrode (91), die mehreren zweiten C-förmigen Ringbereiche (92c) der zweiten Elektrode (92) und der kreisförmige Ringbereich (92d) der zweiten Elektrode (92) eine mittlere Breite von etwa 5 Millimeter aufweisen.

9. Elektrostatische Aufspannvorrichtung nach Anspruch 1, wobei der erste Erstreckungsbereich (91b) und der zweite Erstreckungsbereich (92b) eine Breite von etwa 6 Millimeter aufweisen.

10. Elektrostatische Aufspannvorrichtung nach Anspruch 1, wobei ein Abstand von einem Millimeter zwischen entsprechenden Bereichen der ersten und zweiten Elektroden (91 und 92) aufrechterhalten ist.

11. Elektrostatische Aufspannvorrichtung nach Anspruch 1, wobei ein gesamter Bereich der ersten Elektrode (91) und ein gesamter Bereich der zweiten Elektrode (92) in etwa gleich sind.

## Revendications

1. Support électrostatique comprenant :
une plaque de base métallique (60) ;
un disque en céramique (80) ayant une épaisseur prédéterminée et fixé de façon adhésive à la plaque de base métallique (60) ;
une électrode plane (90) située au milieu du disque en céramique dans le sens de l'épaisseur du disque en céramique ; et
un canal de gaz de refroidissement (81) formé sur la surface supérieure du disque en céramique au dessus de ladite électrode et en deçà d'un bord périphérique externe de l'électrode, le canal de gaz de refroidissement (81) étant défini avec une forme annulaire le long d'un bord périphérique extérieur du disque en céramique (80), l'électrode plane (90) comprenant une première électrode (91) et une deuxième électrode (92),
la première électrode comprenant
une portion de disque (91a) agencée au centre du disque en céramique (80),
une première portion d'extension (91b) s'étendant à partir d'une partie de la portion de disque (91a) vers le bord périphérique extérieur du disque en céramique (80), et
une pluralité de premières portions annulaires en forme de C (91c) à des intervalles prédéterminés de manière à avoir différents diamètres, les premières portions annulaires en forme de C s'étendant en forme de C à partir des deux côtés de la première portion d'extension (91b) autour de ladite portion de disque (91a),
la deuxième électrode (92) comprenant
une deuxième portion d'extension (92b) agencée en face de la première portion d'extension (91b) par rapport à la portion de disque (91a) de la première électrode,
une pluralité de deuxièmes portions annulaires en forme de C (92c) à des intervalles prédéterminées de façon à avoir différents diamètres, les deuxièmes portions annulaires en forme de C s'étendant en forme de C à partir des deux côtés de la deuxième portion d'extension (92b) et étant entrelacées avec la pluralité de premières portions annulaires en forme de C (91c) de la première électrode (91), et
une portion annulaire circulaire (92d) connectée à un bord extérieur de la deuxième portion d'extension (92b) de façon à former le bord périphérique extérieur de la deuxième électrode (92) .

2. Support électrostatique selon la revendication 1, dans lequel l'électrode plane (90) s'étend au-delà du canal de gaz de refroidissement (81).

3. Support électrostatique selon la revendication 1, le support comprenant en outre des orifices d'alimentation en gaz (82) situés dans une pluralité de positions au niveau d'une portion inférieure du canal de gaz de refroidissement (81) et des orifices d'alimentation en gaz (83) situés dans une pluralité de positions sur la périphérie d'une surface du disque en céramique (80) dans le côté central du support.

4. Procédé de fabrication d'un support électrostatique, comprenant les étapes suivantes :
préparer un premier comprimé de matériau en céramique en forme de disque ayant la moitié de l'épaisseur d'un disque de céramique terminé (80) ;
former une électrode (90) sur une surface supérieure du premier comprimé de matériau de céramique ;
préparer un deuxième comprimé de matériau de céramique en forme de disque ayant la moitié de l'épaisseur du disque de céramique terminé et comportant un canal de gaz de refroidissement (81) sur sa surface supérieure à un emplacement qui va recouvrir ladite électrode lorsque le deuxième comprimé de matériau de céramique en forme de disque est placé sur le premier comprimé de matériau de céramique en forme de disque ;
placer le deuxième comprimé de matériau de céramique sur le premier comprimé de matériau de céramique de façon à former un empilage de couches ;
chauffer l'empilage complet pour former le disque de céramique terminé (80) ; et
lier la couche de céramique terminée à une plaque de base métallique (60) au moyen d'une couche adhésive (70),
dans lequel ladite électrode (90) est formée de façon à inclure une première électrode (91) et une seconde électrode (92),
la première électrode étant formée de façon à inclure :
une portion de disque (91a) agencée au centre du disque en céramique (80),
une première portion d'extension (91b) s'étendant à partir d'une partie de la portion de disque (91a) en direction du bord périphérique extérieur du disque en céramique (80), et
une pluralité de premières portions annulaires en forme de C (91c) à des intervalles prédéterminés de façon à avoir différents diamètres, les premières portions annulaires en forme de C s' étendant en forme de C à partir des deux côtés de la première portion d'extension (91b) autour de la portion de disque (91a),
la deuxième électrode (92) étant formée de façon à inclure
une deuxième portion d'extension (92b) agencée en face de la première portion d'extension (91b) par rapport à la portion de disque (91a) de la première électrode,
une pluralité de deuxièmes portions annulaires en forme de C (92c) à des intervalles prédéterminés de façon à avoir différents diamètres, les deuxièmes portions annulaires en forme de C s'étendant en forme de C à partir des deux côtés de la deuxième portion d'extension (92b) et étant entrelacées avec la première pluralité de premières portions annulaires en forme de C (91c) de la première électrode (91), et
une portion annulaire circulaire (92d) connectée à un bord extérieur de la deuxième portion d'extension (92b) de façon à former le bord périphérique de la deuxième électrode (92).

5. Procédé selon la revendication 4, dans lequel la couche adhésive (70) est flexible.

6. Support électrostatique selon la revendication 1, dans lequel l'électrode plane (90) s'étend radialement jusqu'à environ un millimètre en deçà d'un bord périphérique extérieur du disque en céramique (80).

7. Support électrostatique selon la revendication 1, dans lequel chacune des première et deuxième électrodes (91 et 92) est en tungstène ayant une épaisseur comprise entre 10 micromètres et 20 micromètres.

8. Support électrostatique selon la revendication 1, dans lequel la portion de disque (91a) de la première électrode (91) a un diamètre d'environ 30 millimètres, et la pluralité de premières portions annulaires en forme de C (91c) de la première électrode (91), la pluralité de deuxièmes portions annulaires en forme de C (92c) de la deuxième électrode (92), et la portion annulaire circulaire (92d) de la deuxième électrode (92) ont une largeur moyenne d'environ 5 millimètres.

9. Support électrostatique selon la revendication 1, dans lequel la première portion d'extension (91b) et la deuxième portion d'extension (92b) ont une largeur d'environ 6 millimètres.

10. Support électrostatique selon la revendication 1, dans lequel un espace de 1 millimètre est maintenu entre des portions respectives des premières et deuxièmes électrodes (91 et 92).

11. Support électrostatique selon la revendication 1, dans lequel la surface totale de la première électrode (91) est environ égale à la surface totale de la deuxième électrode (92).
